# EUROPEAN PATENT APPLICATION

(11) **EP 2 546 887 A1**
(43) Date of publication of application: **16.01.2013**
(21) Application number: 11753479.2
(22) Date of filing: 11.03.2011
(51) Int. Cl.: H01L 31/04

(54) **OPTICAL POWER GENERATION ELEMENT AND MULTI-JUNCTION THIN FILM SOLAR CELL**

(30) Priority: 12.03.2010 JP 2010055877
(71) Applicant: Sharp Kabushiki Kaisha, Osaka-shi, Osaka 545-8522 (JP)
(72) Inventor: MIYANISHI, Shintaro, Osaka 545-8522 (JP); KOH, Hideki, Osaka 545-8522 (JP); TAKABA, Yoshiroh, Osaka 545-8522 (JP); MIYAMOTO, Ryoji, Osaka 545-8522 (JP); GORAI, Atsushi, Osaka 545-8522 (JP); MATSUBARA, Hiroshi, Osaka 545-8522 (JP); HARA, Junichi, Osaka 545-8522 (JP); SAITO, Masaru, Osaka 545-8522 (JP); MACHIDA, Tomohiro, Osaka 545-8522 (JP)
(74) Representative: Müller - Hoffmann & Partner
(86) International application number: PCT/JP2011/055781
(87) International publication number: WO 2011/111821

(57) **Abstract**

A photovoltaic device includes: a substrate; an electrode (10) disposed on the substrate; a semiconductor i layer (11) made of an amorphous Si-based material and disposed on the electrode (10) so that a Schottky junction is formed between the semiconductor i layer and the electrode (10); and a semiconductor n layer (12) disposed on the semiconductor i layer (11), a member forming the semiconductor i layer (11) has a work function Φi larger than a work function Φe of a member forming the electrode (10), and the member forming the semiconductor i layer (11) has an ionization potential larger than a value determined by adding -0.3 eV to the work function Φe. A multijunction thin film solar cell includes this photovoltaic device as its top cell.

## Description

### TECHNICAL FIELD

The present invention relates to a photovoltaic device and a multijunction thin film solar cell.

### BACKGROUND ART

In these years, in view of the ease of cost reduction and accomplishment of multijunction, technological development for increased efficiency of the thin film solar cell is becoming done actively. In particular, regarding the technological development of the thin film solar cell, development is becoming done actively of a p layer and an i layer for which a wide band gap material is used that will eventually provide an increase of open-circuit voltage Voc in the top cell on the light-incident side of a multijunction thin film solar cell in which a plurality of cells having pn junctions are connected to each other.

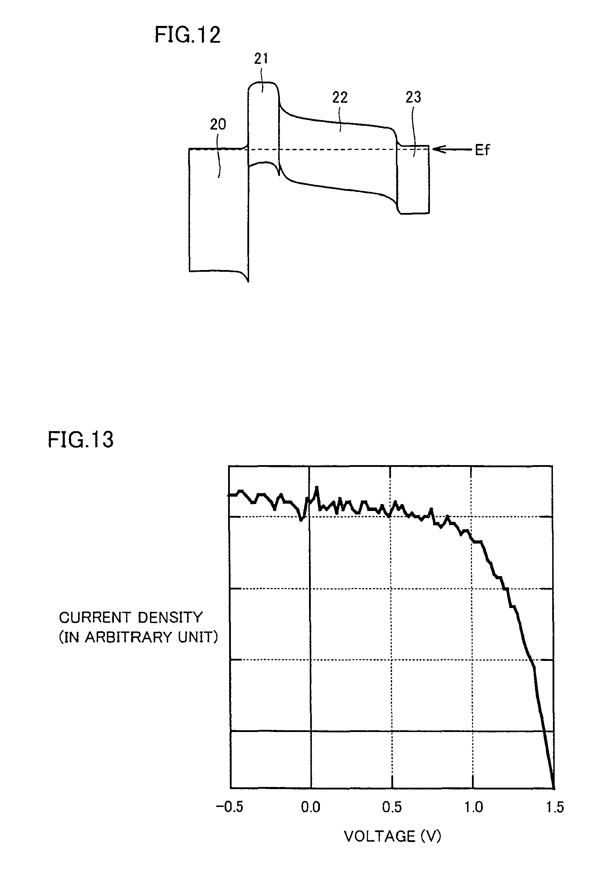

Fig. 12 shows an energy band profile of a conventional common photovoltaic device. Here, in the photovoltaic device having the energy band profile shown in Fig. 12, a semiconductor p layer 21, a semiconductor i layer 22, and a semiconductor n layer 23 are stacked in this order on an electrode 20. In the case where a wide band gap material is used for a photovoltaic device having the layer stack structure as described above, a known problem is that a band offset (band notch) due to a difference of the band gap occurs to semiconductor p layer 21 in the photovoltaic device, resulting in deteriorated properties of the photovoltaic device. In Fig. 12, "Ef" represents Fermi level.

In order to prevent occurrence of the band notch, PTL 1 (Japanese Patent Laying-Open No. 3-101274) for example discloses a cell structure in which a buffer layer is inserted between a p or n layer and an i layer and a graded band gap layer is also formed.

According to PTL 2 (Japanese Patent Laying-Open No. 59-151476), PTL 3 (Japanese Patent Laying-Open No. 62-35681), and PTL 4 (Japanese Utility Model Laying-Open No. 3-36155), a Schottky structure has been devised in which an i layer which is an intrinsic semiconductor is formed on a metal layer or a transparent conductive film without using the p layer and/or the n layer.

### CITATION LIST

### PATENT LITERATURE

PTL 1: Japanese Patent Laying-Open No. 3-101274
PTL 2: Japanese Patent Laying-Open No. 59-151476
PTL 3: Japanese Patent Laying-Open No. 62-35681
PTL 4: Japanese Utility Model Laying-Open No. 3-36155

### SUMMARY OF INVENTION

### TECHNICAL PROBLEM

The photovoltaic device shown in Fig. 12, however, uses a wide band gap material for semiconductor p layer 21 and therefore activation energy Ea of the p layer in semiconductor p layer 21 is no less than at least 0.4 eV. A resultant problem is that open-circuit voltage Voc of the photovoltaic device decreases by this activation energy Ea.

Regarding the method disclosed in PTL 1, a voltage drop in the buffer layer or graded band gap layer which is used for avoiding the band notch causes open-circuit voltage Voc to further decrease, resulting in a problem that the method does not significantly improve the conversion efficiency of the solar cell.

Regarding respective methods disclosed in PTL 2 to PTL 4 as well, there has been a problem that a solar cell with high conversion efficiency cannot be obtained. This is for the following reason. The energy band profile in a cell of an Si-based thin film solar cell has not clearly been identified yet. In particular, no definite solution has still been reached as to what structure is most suitable as the structure of the junction interface between a metal or transparent conductive film and amorphous-based Si.

In view of the circumstances above, an object of the present invention is to provide a photovoltaic device and a multijunction thin film solar cell in which a new energy band profile is introduced to thereby improve their properties.

### SOLUTION TO PROBLEM

The present invention is directed to a photovoltaic device including: a substrate; an electrode disposed on the substrate; a semiconductor i layer made of an amorphous Si-based material and disposed on the electrode so that a Schottky junction is formed between the semiconductor i layer and the electrode; and a semiconductor n layer disposed on the semiconductor i layer. A member forming the semiconductor i layer has a work function Φi larger than a work function Φe of a member forming the electrode. The member forming the semiconductor i layer has an ionization potential larger than a value determined by adding -0.3 eV to the work function Φe.

Preferably, in the photovoltaic device of the present invention, the semiconductor i layer includes a semiconductor iA layer and a semiconductor iB layer laid on the semiconductor iA layer that are stacked in this order on a side of the electrode, the semiconductor iA layer has an ionization potential Eva larger than an ionization potential Evb of the semiconductor iB layer, and the ionization potential Evb is larger than an ionization potential Evn of the semiconductor n layer.

Preferably, in the photovoltaic device of the present invention, the substrate is a translucent substrate and the electrode is a transparent conductive film.

Preferably, in the photovoltaic device of the present invention, the transparent conductive film is SnO₂ or GZO.

Preferably, in the photovoltaic device of the present invention, a Pt layer is included between the transparent conductive film and the semiconductor i layer.

Preferably, in the photovoltaic device of the present invention, the substrate has a column structure made of SiO₂, the electrode is ZnO, the column structure is covered with ZnO, and the semiconductor i layer has a thickness of 100 nm or less.

Preferably, in the photovoltaic device of the present invention, an energy level difference of a valence band and an energy level difference of a conduction band are of respective values substantially equal to each other on a light-incident side of a stack of the semiconductor i layer and the semiconductor n layer and an opposite side to the light-incident side, respectively.

Preferably, in the photovoltaic device of the present invention, the semiconductor i layer has a gradient structure in which a band gap is relatively larger on the light-incident side and the band gap continuously narrows from the light-incident side toward the opposite side.

Preferably, in the photovoltaic device of the present invention, the semiconductor n layer has a thickness of 3 nm or less, a conductive film is disposed on the semiconductor n layer, and a metal film having a larger work function than the work function Φi is included between the semiconductor n layer and the conductive film.

Furthermore, the present invention is directed to a multijunction thin film solar cell including the photovoltaic device as described above as a top cell.

Moreover, the present invention is directed to a photovoltaic device including: an electrode; and a semiconductor layer made of an amorphous Si-based material and disposed on the electrode. An energy level Ev of a valence band at one junction interface between the electrode and the semiconductor layer is larger than a work function Φe of a member forming the electrode.

Moreover, the present invention is directed to a photovoltaic device including: an electrode; and a semiconductor layer made of an amorphous Si-based material and disposed on the electrode. An energy level Ec of a conduction band at one junction interface between the electrode and the semiconductor layer is smaller than a work function Φe of a member forming the electrode.

### ADVANTAGEOUS EFFECTS OF INVENTION

In accordance with the present invention, a photovoltaic device and a multijunction thin film solar cell can be provided in which a new energy band profile is introduced to thereby improve their properties.

### BRIEF DESCRIPTION OF DRAWINGS

Fig. 1 is a diagram showing an example of the energy band profile of a photovoltaic device of a first embodiment.
Fig. 2 is a diagram showing a change of the energy band profile of an amorphous silicon thin film formed by the plasma CVD method using a high-frequency power supply, with respect to the production frequency.
Fig. 3 is a diagram showing another example of the energy band profile of the photovoltaic device of the first embodiment.
Fig. 4 is a diagram showing a positional relationship between work functions, ionization potentials, and energy levels (set values) of the conduction bands of the members that may constitute a photovoltaic device of a second embodiment.
Fig. 5 is a diagram showing a correlation between an energy band profile of the photovoltaic device of the second embodiment and the positions of energy levels (measured values).
Fig. 6 (a) is a diagram showing an energy band profile of a photovoltaic device in a modification of the second embodiment and Fig. 6 (b) is a diagram in which respective energy level differences (ΔEh, ΔEe) of the valence band and the conduction band in Fig. 6 (a) are replaced with respective built-in potentials (ΔVh, ΔVe) of the valence band and the conduction band in a DC battery model.
Fig. 7 is a diagram showing an energy band profile of a photovoltaic device in another modification of the second embodiment.
Fig. 8 is a diagram showing a cross-sectional structure of a photovoltaic device of a third embodiment.
Fig. 9 is a diagram showing an energy band profile of an example of the multijunction thin film solar cell of a fourth embodiment.
Fig. 10 is a diagram showing an energy band profile of another example of the multijunction thin film solar cell of the fourth embodiment.
Fig. 11 is a diagram showing a current-voltage curve (I-V curve) of the photovoltaic device of the first embodiment.
Fig. 12 is a diagram showing an energy band profile of a conventional common photovoltaic device.
Fig. 13 is a diagram showing a current-voltage curve (I-V curve) under a condition that a semiconductor n layer of the photovoltaic device of the first embodiment has a thickness of 1 nm.
Fig. 14 (a) is a diagram showing an energy band profile before an electrode and an interface-controlled semiconductor layer are joined to each other that are included in another example of the photovoltaic device of the first embodiment, and Fig. 14 (b) is a diagram showing an energy band profile after the electrode and the interface-controlled semiconductor layer are joined to each other that are included in the other example of the photovoltaic device of the first embodiment.
Fig. 15 (a) is a diagram showing an energy band profile before an electrode and a semiconductor p layer included in a conventional photovoltaic device are joined to each other, and Fig. 15 (b) is a diagram showing an energy band profile after the electrode and the semiconductor p layer are joined to each other that are included in the conventional photovoltaic device.

### DESCRIPTION OF EMBODIMENTS

In the following, embodiments of the present invention will be described. It should be noted that, in the drawings of the present invention, the same reference characters denote the same or corresponding components.

### <First Embodiment>

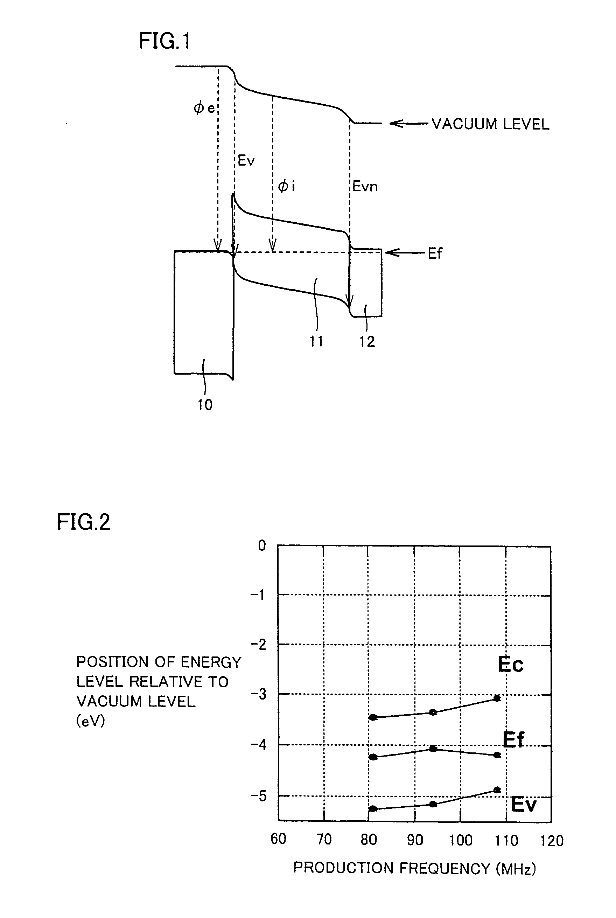

Fig. 1 shows an example of the energy band profile of a photovoltaic device of a first embodiment. The photovoltaic device of the first embodiment includes a substrate (not shown), an electrode 10 disposed on the substrate, a semiconductor i layer 11 made of an amorphous Si-based material and disposed on electrode 10, a semiconductor n layer 12 disposed on semiconductor i layer 11, and a conductive film (not shown) disposed on semiconductor n layer 12.

While Fig. 1 does not show respective energy band profiles of the substrate and the conductive film for the sake of convenience of description, the energy band profile of the substrate is located on the left side of electrode 10 and the energy band profile of the conductive film is located on the right side of semiconductor n layer 12.

Semiconductor i layer 11 is made of an i-type amorphous Si-based material whose main component (50 mass% or more relative to the whole) is amorphous Si (amorphous silicon), and may contain for example at least one element other than Si that is selected from B (boron), C (carbon), N (nitrogen), O (oxygen), Al (aluminum), P (phosphorus), Ga (gallium), Ge (germanium), As (arsenic), and H (hydrogen).

At the interface between electrode 10 and semiconductor i layer 11, a Schottky junction is formed. Height qΦB of the Schottky barrier along the Schottky junction at the interface between electrode 10 and semiconductor i layer 11 is set larger than the value determined by subtracting 0.3 eV from energy band gap Eg of semiconductor i layer 11 (qΦB > Eg - 0.3 eV).

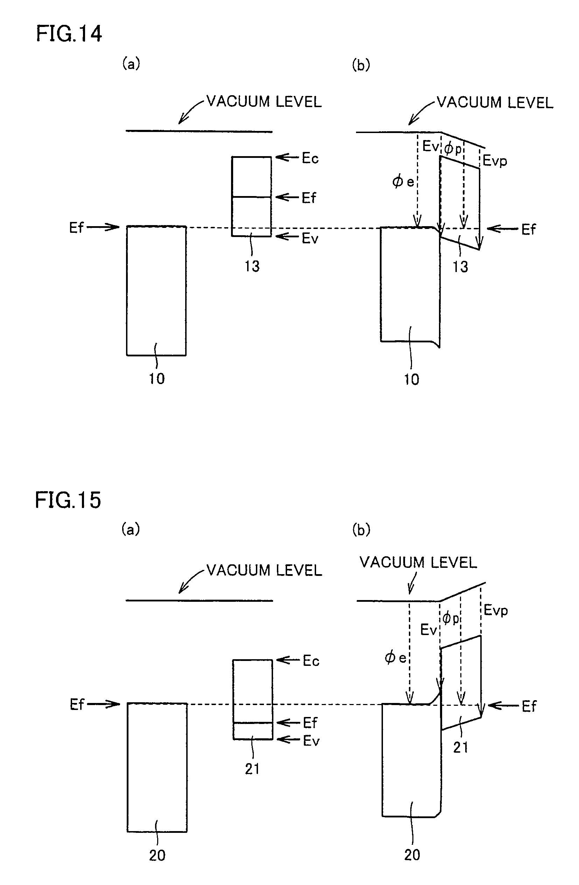

Fig. 14 (a) shows an energy band profile before an electrode and an interface-controlled semiconductor layer are joined to each other that are included in another example of the photovoltaic device of the first embodiment, and Fig. 14 (b) shows an energy band profile after the electrode and the interface-controlled semiconductor layer are joined to each other that are included in the other example of the photovoltaic device of the first embodiment.

As shown in Fig. 14 (a), the energy band of electrode 10 and the energy band of interface-controlled semiconductor layer 13 that are used in the other example of the photovoltaic device of the first embodiment have a relationship therebetween that Fermi level Ef of electrode 10 is located between Fermi level Ef and energy level Ev of the valence band of interface-controlled semiconductor layer 13. Moreover, energy level Ec of the conduction band of interface-controlled semiconductor layer 13 is higher than Fermi level Ef of interface-controlled semiconductor layer 13. In contrast to Fig. 14 (a), energy level Ev of the valence band of interface-controlled semiconductor layer 13 may be higher than (located above) Fermi level Ef of electrode 10.

As shown in Fig. 14 (b), electrode 10 and interface-controlled semiconductor layer 13 are joined to each other to thereby allow Fermi level Ef of electrode 10 to coincide with Fermi level Ef of interface-controlled semiconductor layer 13. Accordingly, at the junction interface between electrode 10 and interface-controlled semiconductor layer 13, an electric field is generated from the electrode 10 side toward the interface-controlled semiconductor layer 13 side. Namely, energy level Ev of the valence band at one junction interface between electrode 10 and interface-controlled semiconductor layer 13 approaches or becomes larger than a value determined by adding -0.3 eV to work function Φe of a member which forms electrode 10.

Thus, the junction interface between electrode 10 and interface-controlled semiconductor layer 13 in the first embodiment serves as a potential barrier for electrons and serves as an ohmic contact for holes. Therefore, at the junction interface between electrode 10 and interface-controlled semiconductor layer 13 in the first embodiment, rectification occurs and recombination current around the junction interface between electrode 10 and interface-controlled semiconductor layer 13 can be reduced. The open-circuit voltage thus tends to increase.

Fig. 15 (a) shows an energy band profile before an electrode and a semiconductor p layer that are included in a conventional photovoltaic device are joined to each other, and Fig. 15 (b) shows an energy band profile after the electrode and the semiconductor p layer that are included in the conventional photovoltaic device are joined to each other.

As shown in Fig. 15 (a), the energy band of electrode 20 and the energy band of semiconductor p layer 21 that are used for the conventional photovoltaic device have a relationship therebetween that Fermi level Ef of electrode 20 is located between Fermi level Ef and energy level Ec of the conduction band of semiconductor p layer 21. Moreover, energy level Ev of the valence band of semiconductor p layer 21 is lower than Fermi level Ef of semiconductor p layer 21.

As shown in Fig. 15 (b), electrode 20 and semiconductor p layer 21 are joined to each other to thereby allow Fermi level Ef of electrode 20 to coincide with Fermi level Ef of semiconductor p layer 21. Accordingly, at the junction interface between electrode 20 and semiconductor p layer 21, an electric field is generated from the semiconductor p layer 21 side toward the electrode 20 side. Namely, energy level Ev of the valence band at one junction interface between electrode 20 and semiconductor p layer 21 is smaller than (located below) a value determined by adding -0.3 eV to work function Φe of a member forming electrode 20.

Thus, it is difficult for the junction interface between electrode 20 and semiconductor p layer 21 in the conventional device to serve as a potential barrier for electron and also difficult for this junction interface to serve as an ohmic contact for holes, as compared with the junction interface of the first embodiment.

For the reason above, the photovoltaic device of the first embodiment has superior properties such as a larger open-circuit voltage as compared with the conventional photovoltaic device.

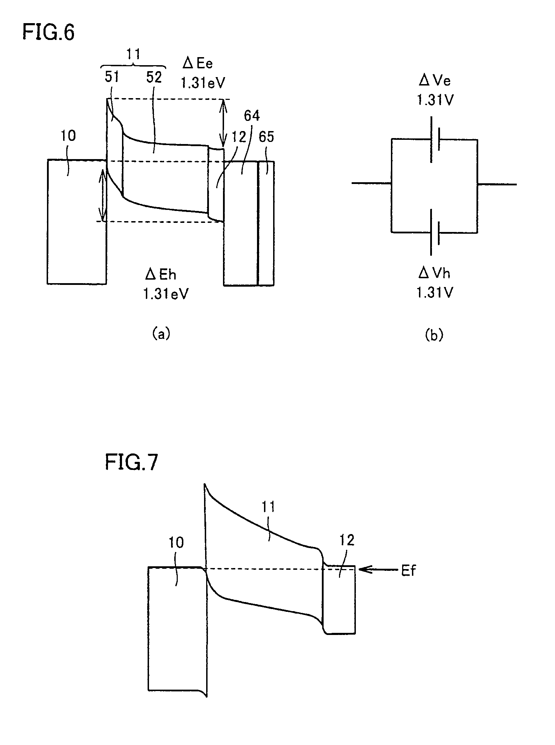

It should be noted that the above description of Fig. 14 (a) and Fig. 14 (b) has been given in connection with the case where a transparent conductive film is used as electrode 10 which is a surface electrode and interface-controlled semiconductor layer 13 is introduced to a location where a semiconductor p layer is used in the conventional art. Alternatively, at the junction interface between a conductive film on the back electrode side (conductive film 64 shown in Fig. 6 (a) for example) and a semiconductor layer (semiconductor n layer 12 shown in Fig. 6 (a) for example), a new interface-controlled semiconductor layer may be introduced instead of the aforementioned semiconductor layer, and energy level Ec of the conduction band of the introduced interface-controlled semiconductor layer may be set smaller than work function Φe of a member forming a back electrode (metal electrode 65 shown in Fig. 6 (a) for example), to thereby enable a junction interface to be formed that serves as an ohmic contact for electrons and as a potential barrier for holes. In this way, a photovoltaic device can be fabricated in which recombination current on the semiconductor n layer side of the conventional art is reduced and the open-circuit voltage is increased.

In Fig. 14 (b), the work function and the ionization potential of interface-controlled semiconductor layer 13, in the case where interface-controlled semiconductor layer 13 is introduced to the location where a semiconductor p layer is used in the conventional art and interface-controlled semiconductor layer 13 is joined to electrode 10, are indicated respectively by Φp and Evp. In Fig. 15 (b), the state of electrons at the junction interface between electrode 20 and semiconductor p layer 21 in the conventional art is shown, and the work function and the ionization potential of semiconductor p layer 21 joined to electrode 20 are indicated respectively by Φp and Evp. It should be noted that an enlarged version of the band profile shape at the junction interface between electrode 20 and semiconductor p layer 21 in Fig. 12 is shown in Fig. 15 (b).

The semiconductor i layer is herein defined as a layer having, in or close to a bulk state where the Schottky junction is absent, Fermi level Ef within an energy level range (Ev+0.3eV < Ef < Ec-0.3eV), namely a range from the level (Ev+0.3eV) determined by adding 0.3 eV to energy level Ev of the valence band relative to the vacuum level to the level (Ec-0.3eV) determined by subtracting 0.3 eV from energy level Ec of the conduction band relative to the vacuum level.

The semiconductor p layer is herein defined as a layer having Fermi level Ef within a range (Ev ≤ Ef ≤ Ev+0.3eV) between the level determined by adding 0.3 eV to energy level Ev of the valence band and energy level Ev of the valence band. The semiconductor p layer may be made for example of a p-type amorphous Si-based material whose main component is amorphous Si.

The semiconductor n layer is herein defined as a layer having Fermi level Ef within a range (Ec-0.3eV ≤ Ef ≤ Ec) between the level (Ec-0.3eV) determined by subtracting 0.3 eV from energy level Ec of the conduction band and energy level Ec of the conduction band. The semiconductor n layer may be made for example of an n-type amorphous Si-based material whose main component is amorphous Si.

The junction formed by the interface between a non-degenerate semiconductor and a metal or the interface between a non-degenerate semiconductor and a degenerate semiconductor is herein broadly defined as a Schottky junction.

How to evaluate Fermi level Ef, valence band Ev, and conduction band Ec is described below. The work function here is defined as a level difference between the vacuum level (0.0 eV) and the Fermi level that is expressed as a negative value in the unit eV. The ionization potential is defined as a level difference between the vacuum level and the Fermi level of a metal or the balance band level of a semiconductor that is expressed as a negative value in the unit eV. A Kelvin probe force microscope (KFM) or the like may be used to measure the profile of a cross section of the photovoltaic device, or sputtering with Ar gas or the like may be performed on a surface of the photovoltaic device while a Kelvin probe force microscope may be used for the etching depth at this time to measure the work function of the surface, for example, to thereby enable the profile of the Fermi level in the photovoltaic device to be evaluated.

Moreover, sputtering milling may be performed on a surface of the photovoltaic device while photoelectron spectroscopy (XPS, UPS) measurement may be conducted to thereby enable the profile of the ionization potential (valence band) in the thickness direction of the photovoltaic device to be evaluated.

Furthermore, inverse photoemission spectroscopy measurement may be done while sputtering milling is performed to thereby enable the profile of the electron affinity (conduction band) in the thickness direction of the photovoltaic device to be evaluated.

An approximate position of the energy level of the conduction band relative to the vacuum level may be defined as a position determined by adding band gap Eg of a semiconductor to the ionization potential (Ec = Ev+Eg). For identification of band gap Eg of the semiconductor, optical band gap (Tauc gap) or the like may be used. From measurement of the oxidation-reduction potential using the cyclic voltammetry (CV) method in a solution, the ionization potential or electron affinity can be determined to identify the energy band profile of the valence band and the conduction band in a cell.

In a semiconductor for which an amorphous Si-based material is used, the conditions under which films/layers are formed by a method such as plasma CVD may be changed to control the positions of the energy levels of conduction band Ec, valence band Ev, and Fermi level Ef.

Fig. 2 shows a change of the energy band profile of an amorphous silicon thin film formed by the plasma CVD method using a high-frequency power supply, with respect to the production frequency. The vertical axis in Fig. 2 represents the position (eV) of the energy level relative to the vacuum level, and the horizontal axis in Fig. 2 represents the production frequency (MHz).

It is seen as shown in Fig. 2 that, depending on the conditions under which the film is formed, respective positions of the energy levels of conduction band Ec and valence band Ev relative to the vacuum level can both be increased while keeping the position of Fermi level Ef of the amorphous silicon film almost unchanged, with respect to an increase of the production frequency.

Thus, semiconductor i layer 11 can be formed by a method based on the plasma CVD using a high-frequency power supply to thereby control respective positions of conduction band Ec, valence band Ev, and Fermi level Ef so that a Schottky junction designed to have a desired energy band profile can be formed at the interface between electrode 10 and semiconductor i layer 11.

On the substrate on which electrode 10 is formed, semiconductor i layer 11 for which an amorphous Si-based material is used is formed, and the Schottky junction is formed between electrode 10 and semiconductor i layer 11. Thus, a built-in potential is applied to semiconductor i layer 11 of the photovoltaic device and no semiconductor p layer is used for the photovoltaic device to thereby enable a decrease of open-circuit voltage Voc of the photovoltaic device, which is caused due to activation energy Ea of the semiconductor p layer, to be reduced. The photovoltaic device having high conversion efficiency can therefore be obtained.

It is preferable to use, as the structure of the top cell on the light-incident side of a multijunction thin film solar cell, the photovoltaic device of the first embodiment which uses no semiconductor p layer. In this case, there is a tendency that scattering of free carriers in the top cell due to infrared radiation applied thereto can be inhibited and the infrared radiation can efficiently be directed to the bottom cell of the multijunction thin film solar cell. In this way, the multijunction thin film solar cell having high conversion efficiency can be obtained.

Work function Φi of the member which forms semiconductor i layer 11 is set larger than work function Φe of the member which forms electrode 10 (Φe < Φi), and the ionization potential (Ev) of the member which forms semiconductor i layer 11 is set larger than the value determined by adding -0.3 eV to work function Φe (Φe-0.3 eV) of the member which forms electrode 10 (Φe-0.3 eV < Ev).

Work function Φi of the member forming semiconductor i layer 11 is thus made larger than work function Φe of the member forming electrode 10 (Φe < Φi). Accordingly, in the case where semiconductor i layer 11 is formed on electrode 10 and the Schottky junction is formed, the built-in potential can be applied to semiconductor i layer 11, and the band offset between the Fermi level (work function Φe) of electrode 10 and the valence band (Ev) of semiconductor i layer 11 at the interface of the Schottky junction can be reduced to less than 0.3 eV. In this way, the photovoltaic device with high conversion efficiency can be obtained.

Owing to the Schottky junction, the built-in potential applied to semiconductor i layer 11 corresponds to the difference between work function Φe of electrode 10 which is almost in the bulk state and work function Φi of the member forming semiconductor i layer 11 Φi - Φe). The band offset between the Fermi level (work function Φe) of electrode 10 and the valence band (Ev) of semiconductor i layer 11 is Φe - Ev (Φe > Ev). It should be noted that the band offset at the interface can be made substantially zero when the condition Φe < Ev is satisfied.

The thickness of semiconductor i layer 11 is preferably set to 500 nm or less. In the case where semiconductor i layer 11 has a thickness of 500 nm or less, there is a tendency that, in the case where the photovoltaic device of the first embodiment is used for a thin film solar cell, the influence of optical degradation of the thin film solar cell can be reduced. The thickness of semiconductor i layer 11 is preferably set to 100 nm or more. In the case where semiconductor i layer 11 has a thickness of 100 nm or more, there is a tendency that, in the case where a multijunction thin film solar cell is formed in which the photovoltaic device of the first embodiment is used as a top cell, the top cell can have a high current density of 7 mA/cm² or more and a high open-circuit voltage of 0.9 V or more.

It is preferable to use semiconductor i layer 11 having an electrical conductivity of 10-⁶ (S/m) or more when a solar spectrum of AM 1.5 is applied. In this case, the ratio of recombined carriers in semiconductor i layer 11 can be reduced. There is thus a tendency that the properties of the photovoltaic device of the first embodiment can be improved.

The thickness of semiconductor n layer 12 is preferably set to 20 nm or less. In the case where semiconductor n layer 12 has a thickness of 20 nm or less, the ratio of recombined carriers in semiconductor n layer 12 can be reduced. There is therefore a tendency that the properties of the photovoltaic device of the first embodiment can be improved. The thickness of semiconductor n layer 12 is also set preferably to 1 nm or more. In the case where semiconductor n layer 12 has a thickness of 1 nm or more, there is a tendency that the energy level can be controlled in the state of semiconductor n layer 12 and a built-in potential can be applied to the inside of semiconductor i layer 11. Semiconductor n layer 12 can also be formed on semiconductor i layer 11 by the plasma CVD method using a high-frequency power supply for example. Fig. 13 shows a current-voltage curve (I-V curve) when the thickness of the semiconductor n layer in the photovoltaic device of the first embodiment is set to 1 nm. It has been confirmed as shown in Fig. 13 that a high open-circuit voltage of 1.4 V or more can be obtained in the case where the thickness of the semiconductor n layer is set to 1 nm.

As the substrate, a translucent substrate is preferably used that allows light from the visible region to the infrared region to pass. Since the mobility of hole carriers in the semiconductor i layer made of an amorphous Si-based material is lower than that of electron carriers, the hole carriers accumulated in an inversion region on the semiconductor i layer 11 side of the Schottky junction interface between electrode 10 and semiconductor i layer 11 are prone to be recombined. Therefore, in the case where such a translucent substrate is used, the amount of light applied to the Schottky junction interface between electrode 10 and semiconductor i layer 11 is largest in the photovoltaic device of the first embodiment. Thus, many carriers generated by the applied light compensate for the defect level at the Schottky junction interface and accordingly there is a tendency that properties of the photovoltaic device of the first embodiment can be improved.

As electrode 10, a transparent conductive film made of a TCO (Transparent Conductive Oxide) such as ITO (Indium Tin Oxide) is preferably used. Since the Schottky junction between electrode 10 and the semiconductor i layer is located near the light-incident side, many photoexcited carriers that have been generated can be trapped by the defect level near the Schottky junction interface. Accordingly, the ratio of recombined hole carriers in the semiconductor i layer 11 that have been accumulated in an inversion region on the semiconductor i layer 11 side of the Schottky junction interface can be reduced, and therefore hole carriers can efficiently been extracted from the Schottky junction interface through electrode 10. Consequently, there is a tendency that the open-circuit voltage and the short-circuit current density of the photovoltaic device can be increased.

As the transparent conductive film of electrode 10, SnO₂ is preferably used. SnO₂ (work function Φe = -4.7 eV) is used as the transparent conductive film to thereby enable the band offset to be 0.3 eV or less of the valence band at the Schottky junction between semiconductor i layer 11 for which an amorphous Si-based material is used and electrode 10. Consequently, there is a tendency that the open-circuit voltage and the short-circuit current density of the photovoltaic device can be increased. It should be noted that the SnO₂ transparent conductive film is doped with an element such as F and its electrical conductivity is thus controlled. In the case where the work function of the transparent conductive film is Φe < -4.7 eV, the open-circuit voltage can be improved. There is a tendency that defects around the junction interface between electrode 10 and semiconductor i layer 11 can be reduced to improve the open-circuit voltage.

As the transparent conductive film for electrode 10, GZO is preferably used. GZO (GaZnO oxide, work function Φe = -5.1 eV) is used as the transparent conductive film to thereby enable the band offset to be 0.1 eV or less of the balance band at the Schottky junction between semiconductor i layer 11 made of an amorphous Si-based material and electrode 10. Consequently, there is a tendency that the open-circuit voltage of the photovoltaic device can be increased.

It should be noted that electrode 10 can be formed on the substrate by a method such as CVD, sputtering, or application for example.

As the conductive film, a transparent and electrically conductive film having a relatively large work function (Φe > -4.3 eV) such as ZnO can be used for example. The conductive film can be formed on semiconductor n layer 12 by CVD, sputtering, or application for example. It should be noted that the ZnO transparent conductive film is doped with an element such as B, Al, Ga, or Mg and its electrical conductivity is thus controlled.

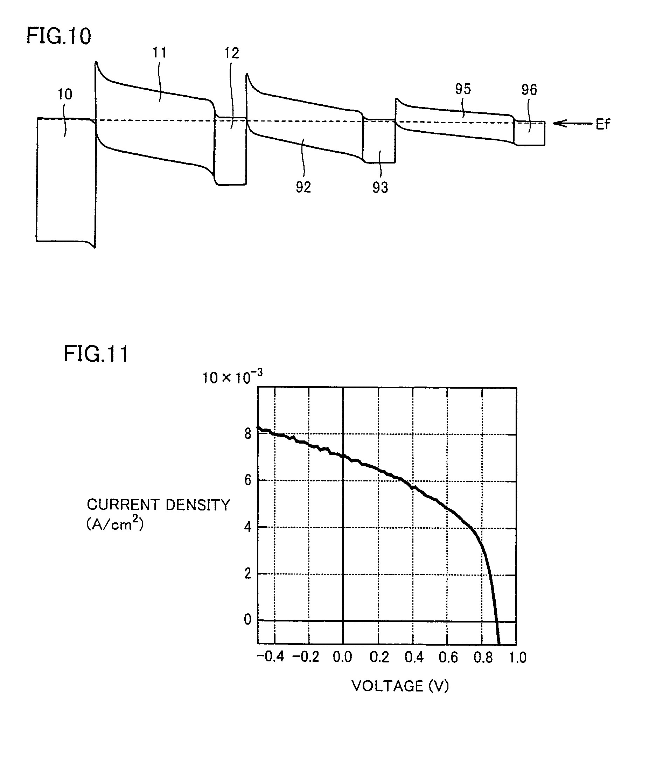

Fig. 11 shows a current-voltage curve (I-V curve) of the photovoltaic device of the first embodiment. The vertical axis in Fig. 11 represents the current density (A/cm²) and the horizontal axis in Fig. 11 represents the voltage (V). It is seen as shown in Fig. 11 that the photovoltaic device of the first embodiment has a high short-circuit current density and a large open-circuit voltage, and thus the photovoltaic device having excellent properties is obtained. In particular, as shown in Fig. 11, the open-circuit voltage of the photovoltaic device of the first embodiment is larger than the open-circuit voltage 0.85 V of the top cell of the conventional multijunction thin film solar cell.

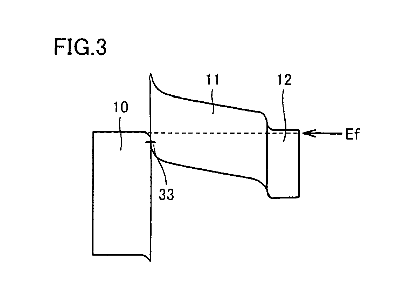

Fig. 3 shows another example of the energy band profile of the photovoltaic device of the first embodiment. As shown in Fig. 3, it is preferable to form a Pt layer 33 between electrode 10 formed of a transparent conductive film and semiconductor i layer 11. At the Schottky junction between semiconductor i layer 11 for which an amorphous Si-based material is used and electrode 10 formed of a transparent conductive film, Pt layer 33 (work function Φe = -5.0 eV) is formed. Accordingly, at an intermediate position of the band offset of the valence band of less than 0.3 eV, an intermediate level corresponding to the work function of Pt layer 33 is formed, and the tunneling probability of hole carriers between semiconductor i layer 11 and electrode 10 increases. Accordingly, there is a tendency that the short-circuit current density of the photovoltaic device can be increased.

The thickness of Pt layer 33 is preferably 3 nm or less. In the case where Pt layer 33 has a thickness of 3 nm or less, absorption of light in Pt layer 33 can be reduced and thus there is a tendency that the short-circuit current density of the photovoltaic device can be increased.

### <Second Embodiment>

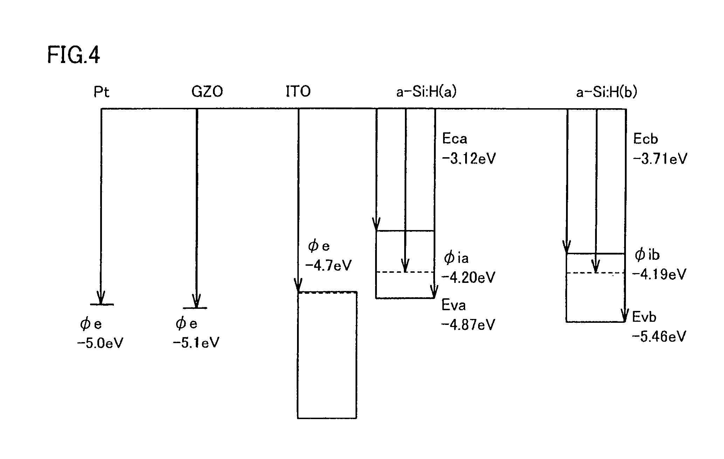

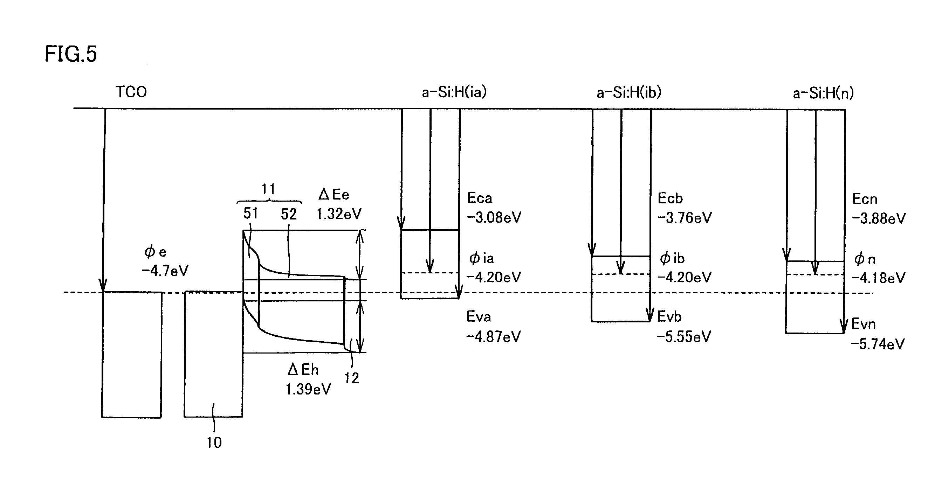

Fig. 4 shows a positional relationship between work functions, ionization potentials, and energy levels (set values) of the conduction bands of the members that may constitute a photovoltaic device of a second embodiment. Fig. 5 shows a correlation between an energy band profile and the positions of the energy levels (measured values) of the photovoltaic device of the second embodiment.

As shown in Fig. 4, work functions Φe of a Pt layer, a GZO layer, and an ITO layer are set respectively to -5.0 eV, -5.1 eV, and -4.7 eV. The energy level of conduction band Eca, work function Φia, and ionization potential Eva of a semiconductor iA layer 51 made of an amorphous Si-based material are set respectively to -3.12 eV, -4.20 eV, and -4.87 eV. The energy level of conduction band Ecb, work function Φib, and ionization potential Evb of a semiconductor iB layer 52 made of an amorphous Si-based material are set respectively to -3.71 eV, -4.19 eV, and -5.46 eV.

The photovoltaic device of the second embodiment is formed as shown by the energy band profile of Fig. 5 by stacking, on a substrate (not shown), electrode 10 for which ITO having the set value shown in Fig. 4 is used as the TCO, semiconductor iA layer 51 for which hydrogenated amorphous silicon (a-Si:H(a)) having the set value shown in Fig. 4 is used, semiconductor iB layer 52 for which hydrogenated amorphous silicon (a-Si:H(b)) having the set value shown in Fig. 4 is used, semiconductor n layer 12, and a conductive film (not shown) in this order. While Fig. 5 also does not show respective energy band profiles of the substrate and the conductive film for the sake of convenience of description, the energy band profile of the substrate is located on the left side of electrode 10 and the energy band profile of the conductive film is located on the right side of semiconductor n layer.

The photovoltaic device of the second embodiment is characterized by that it uses, as semiconductor i layer 11, a layer stack structure made up of two layers (semiconductor iA layer 51, semiconductor iB layer 52) having respective ionization potentials different from each other.

As shown in Fig. 5, respective measured values of the energy level of conduction band Eca, work function Φia, and ionization potential Eva of semiconductor iA layer 51 are -3.08 eV, -4.20 eV, and -4.87 eV, respectively. Respective measured values of the energy level of conduction band Ecb, work function Φib, and ionization potential Evb of semiconductor iB layer 52 are -3.76 eV, -4.20 eV, and -5.55 eV, respectively. Respective measured values of the energy level of conduction band Ecn, work function Φn, and ionization potential Evn of the semiconductor n layer are -3.88 eV, -4.18 eV, and -5.74 eV, respectively. The measured values are determined following the method described above in connection with the first embodiment.

As shown in Fig. 5, in the photovoltaic device of the second embodiment, ionization potential Eva of semiconductor iA layer 51 which is located relatively closer to electrode 10 is larger than ionization potential Evb of semiconductor iB layer 52 laid on semiconductor iA layer 51 (Eva > Evb). Ionization potential Evb of semiconductor iB layer 52 is larger than ionization potential Evn of semiconductor n layer 12 (Evb > Evn).

As shown in Fig. 5, energy level difference ΔEh of the valence band in the semiconductor layer (semiconductor iA layer 51, semiconductor iB layer 52, and semiconductor n layer 12) and energy level difference ΔEe of the conduction band in this semiconductor layer are 1.39 eV and 1.32 eV, respectively.

Energy level differences ΔEh and ΔEe can be determined substantially by calculating the sum of:
the level difference of the valence band between each of semiconductor iA layer 51 and semiconductor iB layer 52, and semiconductor n layer 12 (for ΔEh), and the level difference of the conduction band between each of semiconductor iA layer 51 and semiconductor iB layer 52, and semiconductor n layer 12 (for ΔEe);
the semiconductor Fermi level shift amount of the intrinsic semiconductor layer (semiconductor iA layer 51, semiconductor iB layer 52) and semiconductor n layer 12; and
the work function difference between the Fermi level of the intrinsic semiconductor layer and electrode 10
   (ΔEh = Eva - Evn + semiconductor Fermi level shift amount + work function difference, ΔEe = Eca - Ecn + semiconductor Fermi level shift amount + work function difference). While the Fermi level in the present embodiment is set to around -4.2 eV, it may be set to any of other values.

The semiconductor i layer is divided into the two layers, namely semiconductor iA layer 51 connected to electrode 10 and semiconductor iB layer 52 laid on semiconductor iA layer 51. Regarding semiconductor iA layer 51, ionization potential Eva can be set that is appropriate for forming an energy band profile where the band offset (Φe - Ev) with respect to electrode 10 is less than 0.3 eV, to thereby reduce a voltage drop in the portion connecting electrode 10 and semiconductor iA layer 51.

Ionization potential Eva of semiconductor iA layer 51 can be set larger than ionization potential Evb of semiconductor iB layer 52 (Eva > Evb) to thereby apply a potential difference into the semiconductor i layer (a stack of semiconductor iA layer 51 and semiconductor iB layer 52). Ionization potential Evb of semiconductor iB layer 52 can be set larger than ionization potential Evn of semiconductor n layer 12 (Evb > Evn) to thereby also apply a built-in potential between semiconductor iB layer 52 and semiconductor n layer 12. Owing to these features, the open-circuit voltage of the photovoltaic device is increased and the photovoltaic device with high conversion efficiency can be obtained.

The thickness of semiconductor iA layer 51 is preferably set to 10 nm or less. In the case where semiconductor iA layer 51 has a thickness set to 10 nm or less, the ratio of recombined carriers in semiconductor iA layer 51 can be reduced and thus there is a tendency that the properties of the photovoltaic device of the second embodiment can be improved. In the case where semiconductor iA layer 51 has a thickness of 1 nm or more, there is a tendency that the energy level can be controlled for semiconductor iA layer 51 and a built-in potential can be applied to the interface between electrode 10 and semiconductor iA layer 51.

It is preferable to use semiconductor iB layer 52 having an electrical conductivity of 10-⁶ (S/m) or more when a solar spectrum of AM 1.5 is applied. In this case, there is a tendency that the ratio of recombined carriers in semiconductor iB layer 52 can be reduced.

The thickness of semiconductor iB layer 52 is preferably 500 nm or less. In the case where semiconductor iB layer 52 has a thickness of 500 nm or less, there is a tendency that, in the case where the photovoltaic device of the second embodiment is used for a thin film solar cell, the influence of optical degradation of the thin film solar cell can be reduced. The thickness of semiconductor iB layer 52 is preferably set to 100 nm or more. In the case where semiconductor iB layer 52 has a thickness of 100 nm or more, there is a tendency that, in the case where a multij unction thin film solar cell is formed in which the photovoltaic device of the second embodiment is used as a top cell, the top cell can have a high current density of 7 mA/cm² or more and a high open-circuit voltage of 0.9 V or more.

Semiconductor iA layer 51 and semiconductor iB layer 52 can be formed by the plasma CVD method using a high-frequency power supply in which the conditions under which semiconductor iA layer 51 is formed and the conditions under which semiconductor iB layer 52 is formed are set differently from each other, for example. In this case, semiconductor iA layer 51 and semiconductor iB layer 52 having respective ionization potentials different from each other can be formed.

### <Modification of Second Embodiment>

Fig. 6 (a) shows an energy band profile of a photovoltaic device in a modification of the second embodiment. This modification is characterized by that the energy level difference of the valence band and the energy level difference of the conduction band have the same values (1.31 eV) on the light-incident side and the opposite side to the light-incident side respectively of the semiconductor layer (semiconductor iA layer 51, semiconductor iB layer 52, and semiconductor n layer 12), and that a conductive film 64 and a metal electrode 65 having a high reflectance such as Ag for example are disposed in this order on semiconductor n layer 12.

Fig. 6 (b) shows a diagram in which energy level difference ΔEh of the valence band and energy level difference ΔEe of the conduction band that are shown in Fig. 6 (a) are replaced with respective built-in potentials (ΔVh, ΔVe), in a DC battery model, of the valence band and the conduction band of the semiconductor layer of the photovoltaic device in the modification of the second embodiment. Here, in the photovoltaic device in the modification of the second embodiment, in order to obtain a maximum open-circuit voltage, ΔVh and ΔVe are required to be set to the same values respectively. Thus, the built-in potential of the valence band and the built-in potential of the conduction band applied into the semiconductor layer can be set identical to each other to thereby maximize the open-circuit voltage of the photovoltaic device and accordingly obtain the photovoltaic device having high conversion efficiency.

It should be noted that while it is most preferable to set ΔEh and ΔEe to the same values respectively in order to obtain a maximum open-circuit voltage, they may not be of exactly the same values in view of the purpose of obtaining a photovoltaic device having high conversion efficiency. Specifically, the absolute value of the difference between ΔEh and ΔEe may be 0.3 eV or less (energy level difference ΔEh of the valence band and energy level difference ΔEe of the conduction band may be substantially identical to each other).

### <Another Modification of Second Embodiment>

Fig. 7 shows an energy band profile of a photovoltaic device in another modification of the second embodiment.

The photovoltaic device shown in Fig. 7 is characterized by that it has a gradient structure in which the band gap on the light-incident side (electrode 10 side) of semiconductor i layer 11 is larger than the band gap on the opposite side to the light-incident side and, from the light-incident side toward the opposite side (semiconductor n layer 12 side), the band gap is narrowed continuously.

In such a photovoltaic device as shown in Fig. 7, the gradient structure enables a built-in potential to be applied into semiconductor i layer 11, and therefore, the ratio of recombined carriers in semiconductor i layer 11 can be reduced. In this way, the photovoltaic device having a large short-circuit current density can be obtained.

### <Third Embodiment>

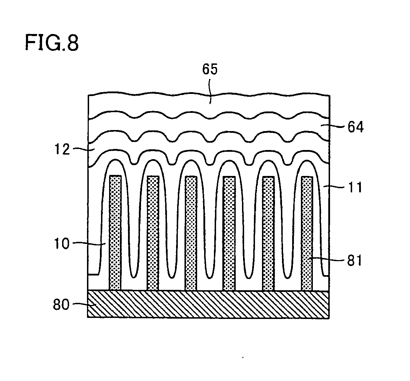

Fig. 8 shows a cross-sectional structure of a photovoltaic device of a third embodiment. Here, in the photovoltaic device of the third embodiment, a substrate 80 has a plurality of cylindrical columns 81 and the surface of columns 81 is covered with an electrode 10 formed of a ZnO thin film.

Columns 81 are made for example of SiO₂, have a diameter for example of 50 nm to 200 nm (particularly 100 nm), have a height for example of 1 µm to 2 µm (particularly 1 µm), and are arranged at a pitch for example of 400 nm to 600 nm. The ZnO thin film which forms electrode 10 has a thickness of 100 nm or less.

Moreover, a semiconductor i layer 11 having a thickness of 100 nm or less is laid on electrode 10, a semiconductor n layer 12 is laid on semiconductor i layer 11, a conductive film 64 formed of a transparent conductive film such as ZnO for example is laid on the surface of semiconductor n layer 12, and a metal electrode 65 having a high reflectance such as Ag for example is laid on conductive film 64. In the case where conductive film 64 is formed of a ZnO film for example, ZnO film may be doped with Al, Na, or Mg.

Between semiconductor n layer 12 and conductive film 64, preferably a film of a metal such as Al, Na, Mg is formed (work function Φe ≥ -4.2 eV). Such a metal film can be formed so that it abuts on semiconductor n layer 12 and conductive film 64 each, to thereby reduce the band offset at the interface between semiconductor n layer 12 and conductive film 64.

It is also preferable that a film of a metal such as Al, Na, Mg having a work function which is set larger than that of the member forming semiconductor i layer 11 and the member forming semiconductor n layer 12 is formed to a thickness of 3 nm or less and that semiconductor n layer 12 is formed to a thickness of 3 nm or less. In this case, a Schottky junction between semiconductor n layer 12 and the metal film such as Al, Na, Mg can be formed to reduce the activation energy of semiconductor n layer 12.

Like the photovoltaic device of the third embodiment, electrode 10 can be formed to cover columns 81 and semiconductor i layer 11 having a thickness of 100 nm or less can be formed to thereby accomplish sufficient light absorption in semiconductor i layer 11 even in the case where semiconductor i layer 11 is formed as a thin film. Accordingly, optical degradation (Staebler-Wronski effect) due to thinned semiconductor i layer 11 made of an amorphous Si-based material can be reduced.

Moreover, semiconductor i layer 11 can be thinned to 100 nm or less to thereby increase the internal electric field to which carriers are sensitive in semiconductor i layer 11, inhibit recombination of carriers in semiconductor i layer 11, and reduce a decrease of the short-circuit current density. In this way, the photovoltaic device having high conversion efficiency can be obtained.

It should be noted that columns 81 can be formed by means of electron beam holography exposure technology, nanoimprint technology, and self-assembled nano-patterning technology using anodization.

### <Fourth Embodiment>

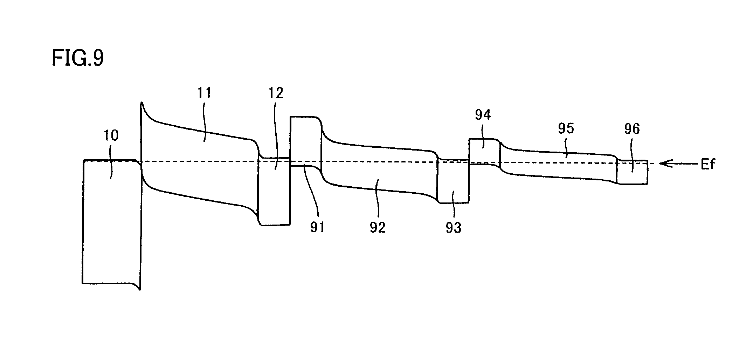

Fig. 9 shows an energy band profile of a multijunction thin film solar cell of a fourth embodiment. The multijunction thin film solar cell of the fourth embodiment is characterized by that a top cell (a stack of a substrate (not shown), an electrode 10, a semiconductor i layer 11, and a semiconductor n layer 12), a middle cell (a stack of a semiconductor p layer 91, a semiconductor i layer 92, and a semiconductor n layer 93), a bottom cell (a stack of a semiconductor p layer 94, a semiconductor i layer 95, and a semiconductor n layer 96), a conductive film formed of a transparent conductive film, and a metal electrode are stacked in this order, and that the photovoltaic device of the first to third embodiments is used as a top cell.

In the multijunction thin film solar cell of the fourth embodiment, a band gap profile adapted to the solar cell spectrum can be accomplished and the properties such as the open-circuit voltage of the top cell in the multijunction thin film solar cell have been improved as compared with the conventional ones, and therefore, the multijunction thin film solar cell having high conversion efficiency can be obtained.

In the multijunction thin film solar cell of the fourth embodiment, solar light enters from the left side in Fig. 9. Fig. 9 does not show respective energy band profiles of the substrate, the conductive film, and the metal electrode for the sake of convenience of description. It should be noted that the energy band profile of the substrate is located on the left side of electrode 10, the energy band profile of the conductive film is located on the right side of semiconductor n layer 96, and the energy band profile of the metal electrode is located on the right side of the conductive film.

Here, band gap energy Eg of semiconductor i layer 11 of the top cell is preferably not less than 1.75 eV and not more than 2.2 eV (particularly 1.8 eV). In this case, there is a tendency that light in the short wavelength range of the solar light can efficiently be absorbed.

Band gap Eg of semiconductor i layer 92 of the middle cell is preferably not less than 1 eV and not more than 1.7 eV (particularly 1.1 eV). In this case, there is a tendency that light in the middle wavelength range of the solar light can efficiently be absorbed. Semiconductor i layer 92 of the middle cell is preferably formed of microcrystalline Si in terms of the fact that current matching between the layers in the multijunction thin film solar cell can be facilitated.

Band gap Eg of semiconductor i layer 95 of the bottom cell is preferably not less than 0.5 eV and not more than 1 eV (particularly not more than 0.7 eV). In this case, there is a tendency that light in the long wavelength range of the solar light can efficiently be absorbed. Semiconductor i layer 95 of the bottom cell is preferably formed of microcrystalline Si in terms of the fact that current matching between the layers in the multijunction thin film solar cell can be facilitated

While the fourth embodiment has been explained by way of example regarding the case where three cells, namely top cell, middle cell, and bottom cell are included, the number of constituent cells may be two or three or more.

Fig. 10 shows an energy band profile of still another example of the multijunction thin film solar cell of the fourth embodiment. As shown in Fig. 10, the Schottky junction may be used not only for the top cell but also the middle cell (stack of semiconductor i layer 92 and semiconductor n layer 93) and the bottom cell (stack of semiconductor i layer 95 and semiconductor n layer 96).

### INDUSTRIAL APPLICABILITY

The present invention is applicable to photovoltaic devices and multijunction thin film solar cells.

### REFERENCE SIGNS LIST

10 electrode; 11 semiconductor i layer; 12 semiconductor n layer; 13 interface-controlled semiconductor layer; 20 electrode; 21 semiconductor p layer; 22 semiconductor i layer; 23 semiconductor n layer; 33 Pt layer; 51 semiconductor iA layer; 52 semiconductor iB layer; 64 conductive film; 65 metal electrode; 80 substrate; 81 column; 91 semiconductor p layer; 92 semiconductor i layer; 93 semiconductor n layer; 94 semiconductor p layer; 95 semiconductor i layer; 96 semiconductor n layer

## Claims

1. A photovoltaic device comprising:
a substrate;
an electrode (10) disposed on said substrate;
a semiconductor i layer (22) made of an amorphous Si-based material and disposed on said electrode (10) so that a Schottky junction is formed between the semiconductor i layer and said electrode (10); and
a semiconductor n layer (12) disposed on said semiconductor i layer (22), wherein
a member forming said semiconductor i layer (22) has a work function Φi larger than a work function Φe of a member forming said electrode (10), and
the member forming said semiconductor i layer (22) has an ionization potential larger than a value determined by adding -0.3 eV to said work function Φe.

2. The photovoltaic device according to claim 1, wherein
said semiconductor i layer (11) includes a semiconductor iA layer (51) and a semiconductor iB layer (52) laid on said semiconductor iA layer (51) that are stacked in this order on a side of said electrode (10),
said semiconductor iA layer (51) has an ionization potential Eva larger than an ionization potential Evb of said semiconductor iB layer (52), and
said ionization potential Evb is larger than an ionization potential Evn of said semiconductor n layer (12).

3. The photovoltaic device according to claim 1 or 2, wherein said substrate is a translucent substrate and said electrode (10) is a transparent conductive film.

4. The photovoltaic device according to claim 3, wherein said transparent conductive film is SnO₂ or GZO.

5. The photovoltaic device according to claim 3 or 4, wherein a Pt layer is included between said transparent conductive film and said semiconductor i layer.

6. The photovoltaic device according to any of claims 1 to 5, wherein
said substrate (80) has a column (81) made of SiO₂,
said electrode (80) is ZnO,
said column (81) is covered with said electrode (80), and
said semiconductor i layer (11) has a thickness of 100 nm or less.

7. The photovoltaic device according to any of claims 1 to 6, wherein an energy level difference of a valence band and an energy level difference of a conduction band are of respective values substantially equal to each other on a light-incident side of a stack of said semiconductor i layer (11) and said semiconductor n layer (12) and an opposite side to said light-incident side, respectively.

8. The photovoltaic device according to any of claims 1 to 6, wherein said semiconductor i layer (11) has a gradient structure in which a band gap is relatively larger on said light-incident side and the band gap continuously narrows from said light-incident side toward the opposite side.

9. The photovoltaic device according to any of claims 1 to 8, wherein
said semiconductor n layer (12) has a thickness of 3 nm or less,
a conductive film (64) is disposed on said semiconductor n layer (12), and
a metal film having a larger work function than said work function Φi is included between said semiconductor n layer (12) and said conductive film (64).

10. A multijunction thin film solar cell comprising the photovoltaic device recited in any of claims 1 to 9 as a top cell.

11. A photovoltaic device comprising:
an electrode (10); and
a semiconductor layer (13) made of an amorphous Si-based material and disposed on said electrode (10), wherein
an energy level Ev of a valence band at one junction interface between said electrode (10) and said semiconductor layer (13) is larger than a work function Φe of a member forming said electrode (10).

12. A photovoltaic device comprising:
an electrode (64, 65); and
a semiconductor layer (12) made of an amorphous Si-based material and disposed on said electrode (64, 65), wherein
an energy level Ec of a conduction band at one junction interface between said electrode (64, 65) and said semiconductor layer (12) is smaller than a work function Φe of a member forming said electrode (64, 65).
